# EUROPEAN PATENT APPLICATION

(11) **EP 2 822 051 A2**
(43) Date of publication of application: **07.01.2015**
(21) Application number: 14162166.4
(22) Date of filing: 28.03.2014
(51) Int. Cl.: H01L 51/50, H01L 27/32

(54) **Organic light emitting diode display**

(30) Priority: 02.07.2013 KR 20130077372
(71) Applicant: Samsung Display Co., Ltd., Gyeonggi-Do (KR)
(72) Inventor: Oh, Il-Soo, SEOUL (KR); Lee, Chang-Ho, Suwon-si, Gyeonggi-do (KR); Yoon, Ji Hwan, Yongin-si, Gyeonggi-do (KR); Shin, Dae-Yup, Suwon-si, Gyeonggi-do (KR); Ko, Hee-Joo, Suwon-si, Gyeonggi-do (KR); Cho, Se-Jin, Seoul (KR); Yun, Jin-Young, Hwaseong-si, Gyeonggi-do (KR); Lee, Bora, Hwaseong-si, Gyeonggi-do (KR); Lee, Yeon-Wo, Jincheon-gun, Chungcheongbuk-do (KR); Kim, Beom-Joon, Mapo-Gu, Seoul (KR); Jeon, Pyung-Eun, Seoul (KR); Choi, Hyun-Ju, Seoul (KR); Sim, Joong-Won, SEOUL (KR); Lee, In-Jae, Busan (KR)
(74) Representative: Gulde & Partner

(57) **Abstract**

An organic light emitting diode (OLED) display includes a substrate (123), a thin film transistor (130) formed on the substrate, a first electrode (160) formed on the thin film transistor and electrically connected to the thin film transistor, a hole injection layer (HIL) (171) formed on the first electrode, a hole transport layer (HTL) (172) formed on the hole injection layer (HIL), an emission layer (173) formed on the HTL, an electron transport layer (ETL) (174) formed on the emission layer, a first buffer layer (175) located on the ETL, and a second electrode (180) formed on the first buffer layer.

## Description

The present invention relates to an organic light emitting diode (OLED) display.

### DISCUSSION OF RELATED ART

Organic light emitting diode (OLED) displays are self-emissive using organic light emitting diodes. Holes and electrons are injected into the emission layer, and are recombined in the emission layer to generate excitons, thereby emitting light to display an image.

OLED displays include a pixel electrode and a common electrode to provide holes and electrons, respectively. The common electrode is formed using a sputtering process.

### SUMMARY

According to the present invention there is provided an organic light emitting diode (OLED) display including a substrate, a thin film transistor formed on the substrate, a first electrode formed on the thin film transistor and electrically connected to the thin film transistor, a hole injection layer (HIL) formed on the first electrode, a hole transport layer (HTL) formed on the hole injection layer (HIL), an emission layer formed on the HTL, an electron transport layer (ETL) formed on the emission layer, a first buffer layer located on the ETL, and a second electrode formed on the first buffer layer.

Further embodiments of the invention could be learned from the dependent claims and following description.

### BRIEF DESCRIPTION OF THE DRAWINGS

These and other features of the present invention will become more apparent by describing in detail exemplary embodiments thereof with reference to the accompanying drawings of which:
FIG. 1 is a cross-sectional view illustrating an organic light emitting diode (OLED) display according to an exemplary embodiment of the present invention;
FIG. 2 is an enlarged cross-sectional view of an OLED display according to an exemplary embodiment of the present invention;
FIG. 3 is an enlarged cross-sectional view of an OLED display according to an exemplary embodiment of the present invention;
FIG. 4 is an enlarged cross-sectional view of an OLED display according to an exemplary embodiment of the present invention; and
FIG. 5 and FIG. 6 are graphs illustrating light intensity and luminous efficiency of the OLED display according to an exemplary embodiment of the present invention.

### DETAILED DESCRIPTION OF THE EXEMPLARY EMBODIMENTS

Exemplary embodiments of the inventive concept will be described below in detail with reference to the accompanying drawings. In the drawings, the thickness of layers and regions may be exaggerated for clarity. It will also be understood that when an element is referred to as being "on" another element or substrate, it may be directly on the other element or substrate, or intervening layers may also be present. Like reference numerals may refer to the like elements throughout the specification and drawings.

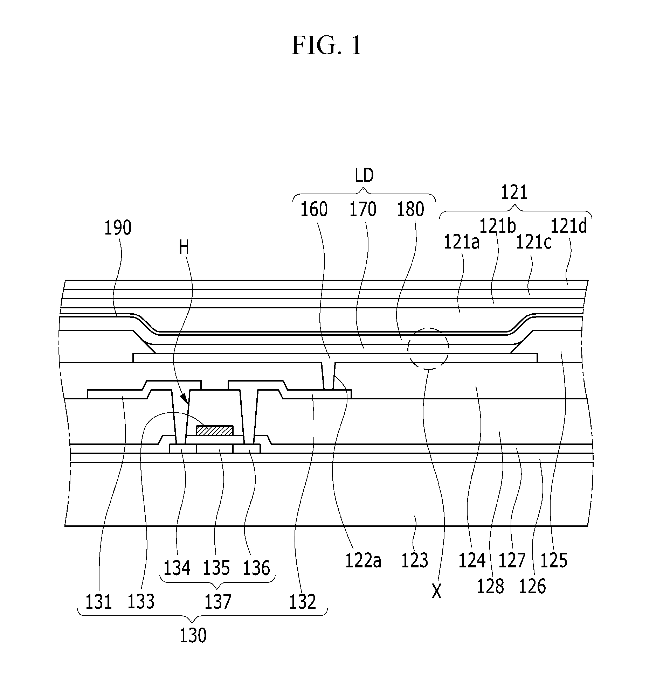

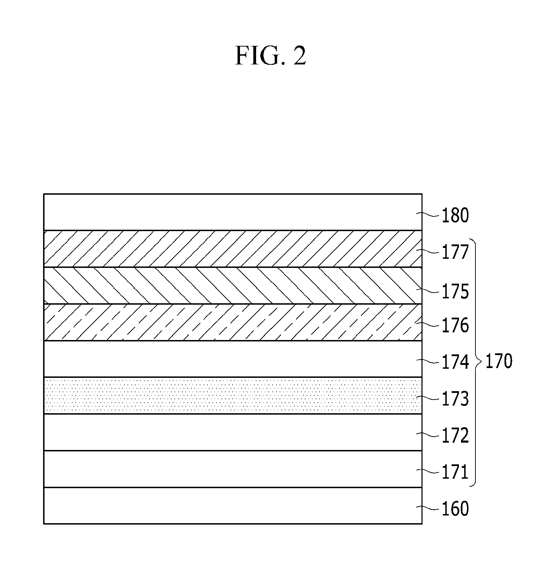

Hereinafter, the configuration of an organic light emitting diode (OLED) display according to an exemplary embodiment will be described with reference to FIGS. 1 and 2. FIG. 1 is a cross-sectional view illustrating the organic light emitting diode (OLED) display. FIG. 2 is an enlarged cross-sectional view of the OLED display. The configuration of the OLED display may prevent damage to an organic light emitting element due to a sputtering process, and thus increase its luminous efficiency.

The OLED display includes a substrate 123, a thin film transistor 130, a first (pixel) electrode 160, a hole injection layer (HIL) 171, a hole transport layer (HTL) 172, an emission layer 173, an electron transport layer (ETL) 174, a first buffer layer 175, a second buffer layer 176, a third buffer layer 177, and a second (common) electrode 180.

The substrate 123 may be formed of an insulating substrate made of glass, quartz, ceramic, plastic, and the like. However, and the substrate 123 may also be formed as a metallic substrate made of stainless steel and the like.

A buffer layer 126 is formed on the substrate 123. The buffer layer 126 serves to prevent penetration of impurity elements and planarize the surface of the substrate 123. The buffer layer 126 may be formed of various materials including silicon nitride (SiNₓ), silicon oxide (SiO₂), or silicon oxynitride (SiOₓN_{y}). Alternatively, the buffer layer 126 may be omitted according to the type of the substrate 123 and the condition of a process performed on the substrate 123.

A driving semiconductor layer 137 is formed on the buffer layer 126. The driving semiconductor layer 137 may be formed of a polysilicon film. The driving semiconductor layer 137 includes a channel region 135, and a source region 134 and a drain region 136 which are doped and formed at opposite sides of the channel region 135. In this case, the doped impurities may be p-type impurities such as boron (B). For example, B₂H₆ may be used for doping boron into the source and drain regions 134 and 136. The doped impurities are not limited thereto, and may be various kinds of impurities according to the kind of a thin film transistor.

A gate insulating layer 127 may be formed of silicon nitride (SiNₓ) or silicon oxide (SiO₂). The gate insulating layer 127 is formed on the driving semiconductor layer 137.

A driving gate electrode 133 is formed on the gate insulating layer 127. The driving gate electrode 133 overlaps at least the channel region 135 of the driving semiconductor layer 137.

An interlayer insulating layer 128 covers the driving gate electrode 133. The interlayer insulating layer 128 is formed on the gate insulating layer 127. Through holes H penetrates the interlayer insulating layer 128 and the gate insulating layer 127 to expose the source region 134 and the drain region 136. The interlayer insulating layer 128 may be formed of an insulating material such as silicon nitride (SiNₓ) and silicon oxide (SiO₂) similar to the gate insulating layer 127.

A data wire including a driving source electrode 131 and a driving drain electrode 132 is formed on the interlayer insulating layer 128. The driving source electrode 131 and the driving drain electrode 132 are respectively connected to the source region 134 and the drain region 136 of the driving semiconductor layer 137 via through holes H formed in the interlayer insulating layer 128 and the gate insulating layer 127.

The driving thin film transistor 130 including the driving semiconductor layer 137, the driving gate electrode 133, the driving source electrode 131, and the driving drain electrode 132 is formed. The configuration of the driving thin film transistor 130 is not limited thereto, and may be variously changed.

A planarization film 124 covering the data wire is formed on the interlayer insulating layer 128. The planarization layer 124 serves to planarize the interlayer insulating layer 128 to increase the light emitting efficiency of the organic light emitting element to be formed thereon. An electrode contact hole 122a penetrates the planarization layer 124 to expose a part of the drain electrode 132.

The planarization layer 124 may include polyacrylate resin, epoxy resin, phenolic resin, polyamide resin, polyimide resin, unsaturated polyesters resin, polyphenylenether resin, polyphenylene sulfide resin, or benzocyclobutene (BCB).

Alternatively, one of the planarization layer 124 and the interlayer insulating layer 128 may be omitted.

The pixel electrode 160 serving as a first electrode of the organic light emitting element is formed on the planarization layer 124. The OLED display includes a plurality of pixel electrodes 160. Each pixel electrode 160 is formed for a corresponding pixel of a plurality of pixels. Each pixel electrode 160 is spaced from each other. The pixel electrode 160 is connected to the drain electrode 132 through an electrode contact hole 122a.

A pixel defining layer 125 is formed on the planarization layer 124. The pixel defining layer 125 includes a plurality of openings. Each opening is formed for each pixel. An organic emission layer 170 is formed in the opening of the pixel defining layer 125. Accordingly, a pixel region including an organic emission layer is defined by the pixel defining layer 125.

The pixel defining layer 125 partially covers the pixel electrode 160 so that the opening of the pixel defining layer 125 exposes the pixel electrode. For example, the pixel electrode 160 is partially disposed beneath the pixel defining layer 125, and the pixel electrode 160 is partially overlapped by the pixel defining layer 125.

The pixel defining layer 125 may be formed of a resin such as polyacrylate resin and polyimide resin or a silica-based inorganic material.

The organic emission layer 170 is formed on the pixel electrode 160. A detailed configuration of the organic emission layer 170 will be descried hereinafter.

A common electrode 180 serving as a second electrode of the organic light emitting element is formed on the organic emission layer 170. As such, an organic light emitting element LD including the pixel electrode 160, the organic emission layer 170, and the common electrode 180 is formed.

The pixel electrode 160 and the common electrode 180 may be formed of a transparent conductive material, or a semitransparent or reflective conductive material. The OLED display may be a top emission type, a bottom emission type, or a both-side emission type according the material of the pixel electrode 160 and the common electrode 180.

A cover film 190 covers the common electrode 180 to protect the common electrode 180. The cover film 190 may be formed of an organic film.

A thin film encapsulation layer 121 is formed on the cover layer 190. The thin film encapsulation layer 121 seals and protects the organic light emitting element LD and a driving circuit portion formed on the substrate 123 from the outside.

The thin film encapsulation layer 121 includes a plurality of encapsulation films 121 a to 121d stacked on each other. The encapsulation films 121 a and 121 c may be formed of an organic material. The encapsulation films 121b and 121d may be formed of an inorganic material. The structure of the thin film encapsulation layer 121 is not limited thereto, but it may be layered in various ways.

FIG. 2 is an enlarged cross-sectional view of an organic light emitting element according to an exemplary embodiment of the present invention. FIG. 2 shows an enlarged view of an organic light emitting element LD of FIG. 1.

Referring to FIG. 2, the organic light emitting element LD (portion X of FIG. 1) includes the first electrode 160, the HIL 171, the HTL 172, the emission layer 173, the ETL 174, the second buffer layer 176, the first buffer layer 175, the third buffer layer 177, and the second electrode 180 that are stacked on each other.

The organic emission layer 170 of FIG. 1 includes the HIL 171, the HTL 172, the emission layer 173, the ETL 174, the second buffer layer 176, the first buffer layer 175, and the third buffer layer 177.

The HIL 171 is (directly) disposed on the first electrode 160. The HIL 171 serves to inject holes from the first electrode 160 into the HTL 172. The HIL 171 may be formed of copper phthalocyanine (CuPc), poly(3,4-ethylenedioxythiophene) (PEDOT), polyaniline (PANI), or N,N'-diphenyl-N,N'-di-[4-(N,N-diphenyl-amino)phenyl]benzidine (NPNPB).

The thickness of the HIL 171 may range from 25 nm to 35 nm. For example, the thickness of the HIL 171 may be about 30 nm.

The HTL 172 is (directly) disposed on the HIL 172. The HTL 172 serves to transport the holes from the HIL 171 to the emission layer 173. For example, the HTL 172 may be formed of N,N-di(1-naphthyl)-N,N'-di(phenyl)benzidine (NPD), N,N'-bis(3-methylphenyl)-N,N'-bis(phenyl) (TPD), s-TAD, or 4,4',4"-tris(N-3-methylphenyl-N-phenyl-amino)-triphenylamine (MTDATA).

The thickness of the HTL 172 may range from 15 nm to 25 nm. For example, the thickness of the HTL 172 may be about 20 nm.

The emission layer 173 is (directly) formed on the HTL 172 and contains a light emitting material for displaying a predetermined color. For example, the emission layer 173 may display a primary color such as blue, green, or red, or a combination thereof.

The thickness of the emission layer 173 may range from 15 nm to 25 nm. For example, the thickness of the emission layer 173 may be about 20 nm.

The emission layer 173 may be formed of a host material and a dopant.

For red light, the emission layer 173 may contain carbazole biphenyl (CBP) or 1,3-bis(carbazol-9-yl) (mCP) as a host material, and PIQIr(acac) (bis(1-phenylisoquinoline)acetylacetonate iridium), PQIr(acac) (bis(1-phenylquinoline)acetylacetonate iridium), PQIr (tris(1-phenylquinoline)iridium), or PtOEP (platinum octaethylporphyrin) as a dopant.

For green light, the emission layer 173 may contain CBP or mCP as a host material, and Ir(ppy)3 (fac-tris(2-phenylpyridine)iridium) or having Alq3 (tris(8-hydroxyquinolino)aluminum) as a dopant.

For blue light, the emission layer 173 may contain CBP or mCP as a host material, and (4,6-F2ppy)2Irpic as a dopant. Alternatively, the emission layer 173 may be formed of a phosphorescent material including spiro-DPVBi, spiro-6P, distyryl benzene (DSB), distyryl arylene (DSA), a PFO-based polymer, or a PPV-based polymer.

The ETL 174 is (directly) disposed on the emission layer 173. The ETL 174 serves to electrons from the second electrode 180 to the emission layer 173. Further, the ETL 174 serves to prevent the holes injected from the first electrode 160 from moving to the second electrode 180 through the emission layer 173. Hence, the ETL 174 serves as a hole blocking layer and thereby improves combination of the holes and electrons in the emission layer 173.

The ETL 174 may be formed of Alq3 (tris(8-hydroxyquinolino)aluminum), PBD, TAZ, spiro-PBD, BAlq, or SAlq.

The second buffer layer 176 is (directly) disposed on the ETL 174.

The second buffer layer 176 serves to inject electrons from the first buffer layer 175 into the ETL 174. The second buffer layer 176 may be formed of LiF, Yb, WO₃, MoOₓ, Liq, or Mg. Herein, the MoOₓ indicates a molybdenum oxide.

The thickness of the second buffer layer 176 may range from 1 nm to 3 nm. For example, the thickness of the second buffer layer 176 may be about 2 nm.

The first buffer layer 175 is (directly) disposed on the second buffer layer 176. The second buffer layer 176 is disposed between the first buffer layer 175 and the ETL 174.

The first buffer layer 175 facilitates smooth movement of the electrons transferred from the second electrode 180 to a layer having higher electron mobility. The first buffer layer 175 may be formed of copper phthalocyanine (CuPc), copper hexadecafluorophthalocyanine (F₁₆CuPc), molybdenum oxide (MoOₓ), tungsten trioxide (WO₃), or HAT-CN. Alternatively, the first buffer layer 175 may be formed of a polycrystalline organic or inorganic material having high electron mobility.

The thickness of the first buffer layer 175 may range from 85 nm to 95 nm. For example, the thickness of the first buffer layer 175 may be about 90 nm to increase the luminous efficiency of the OLED display. The luminous efficiency of the OLED display may be maximized at such thickness. The luminous efficiency of the OLED display according to an exemplary embodiment will be described hereinafter.

The first buffer layer 175 serves to prevent damage to the emission layer 173 from occurring from a sputtering process for forming the common electrode 180.

The third buffer layer 177 is disposed between the first buffer layer 175 and the second electrode 180.

The third buffer layer 177 serves to inject electrons from the second electrode 180 into the first buffer layer 175. The third buffer layer 177 may be formed of lithium fluoride (LiF), Yb, WO₃, MoOₓ, Liq, or Mg. Herein, the MoOₓ indicates various molybdenum oxides.

The thickness of the third buffer layer 177 may range from 1 nm to 3 nm. For example, the thickness of the third buffer layer 177 may be about 2 nm.

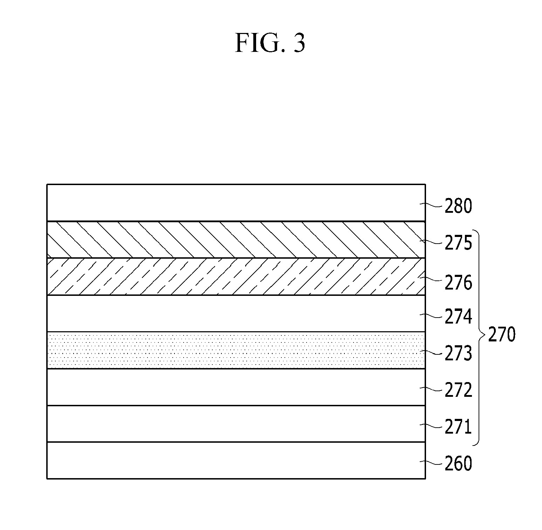

FIG. 3 is an enlarged cross-sectional view of an organic light emitting element according to an exemplary embodiment of the present invention. FIG. 3 shows an enlarged view of an organic light emitting element LD (portion X) of FIG. 1. The organic light emitting element LD of FIG. 3 is substantially similar to that of FIG. 2, except that the third buffer layer 177 of FIG. 2 is omitted. Hereinafter, differences will be described in detail, and the description of the same elements will be omitted.

Referring to FIG. 3, the organic light emitting element LD of FIG. 3 includes a second buffer layer 276, a first buffer layer 275, and a second electrode 280 that are sequentially stacked on an ETL 274.

The second buffer layer 276 serves to inject electrons from the first buffer layer 275 into the ETL 274. The second buffer layer 276 may be formed of LiF, Yb, WO₃, MoOₓ, Liq, or Mg. Herein, the MoOₓ indicates a molybdenum oxide.

The thickness of the second buffer layer 276 may range from 1 nm to 3 nm. For example, the thickness of the second buffer layer 276 may be about 2 nm.

The first buffer layer 275 facilitates smooth movement of the electrons transferred from the second electrode 280 to a layer having higher electron mobility. The first buffer layer 275 may be formed of copper phthalocyanine (CuPc), copper hexadecafluorophthalocyanine (F₁₆CuPc), molybdenum oxide (MoOₓ), tungsten trioxide (WO₃), or HAT-CN. Alternatively, the first buffer layer 275 may be formed of a polycrystalline organic or inorganic material having high electron mobility.

The thickness of the first buffer layer 275 may range from 85 nm to 95 nm. For example, the thickness of the first buffer layer 275 may be about 90 nm.

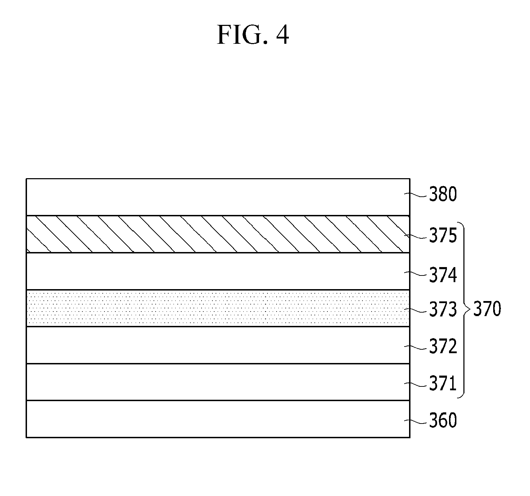

FIG. 4 is an enlarged cross-sectional view of an organic light emitting element according to an exemplary embodiment of the present invention. FIG. 4 shows an enlarged view of an organic light emitting element LD (portion X) of FIG. 1. The organic light emitting element LD of FIG. 4 is substantially similar to that of FIG. 2, except that the second and third buffer layers 176 and 177 of FIG. 2 are omitted. Hereinafter, differences will be described in detail, and the description of the same elements will be omitted.

Referring to FIG. 4, the organic light emitting element LD includes a first buffer layer 375 and a second electrode 380 that are sequentially stacked on an ETL 374.

The first buffer layer 375 facilitates smooth movement of the electrons, transferred from the second electrode 380, to a layer having higher electron mobility. The first buffer layer 375 may be formed of copper phthalocyanine (CuPc), copper hexadecafluorophthalocyanine (F₁₆CuPc), molybdenum oxide (MoOₓ), tungsten trioxide (WO₃), or HAT-CN. Alternatively, the first buffer layer 375 may be formed of a polycrystalline organic or inorganic material having high electron mobility.

The thickness of the first buffer layer 375 may range from 85 nm to 95 nm. For example, the thickness of the first buffer layer 375 may be about 90 nm.

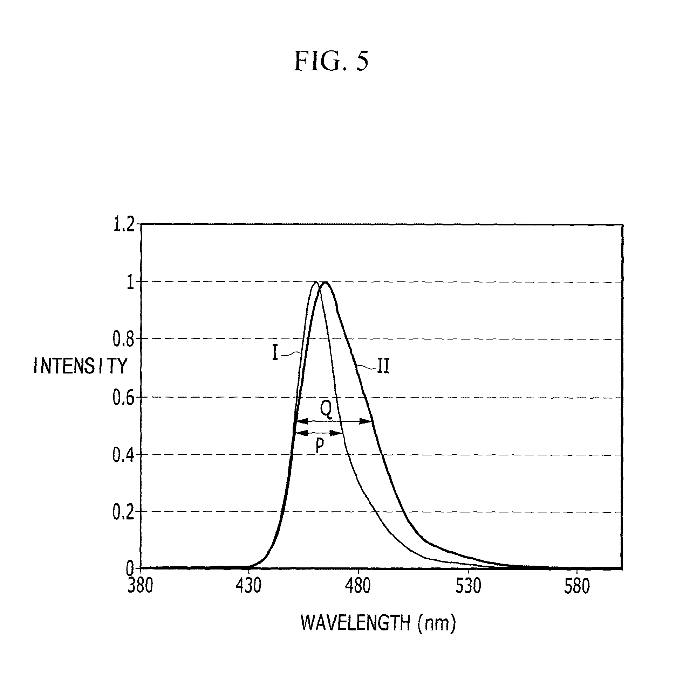

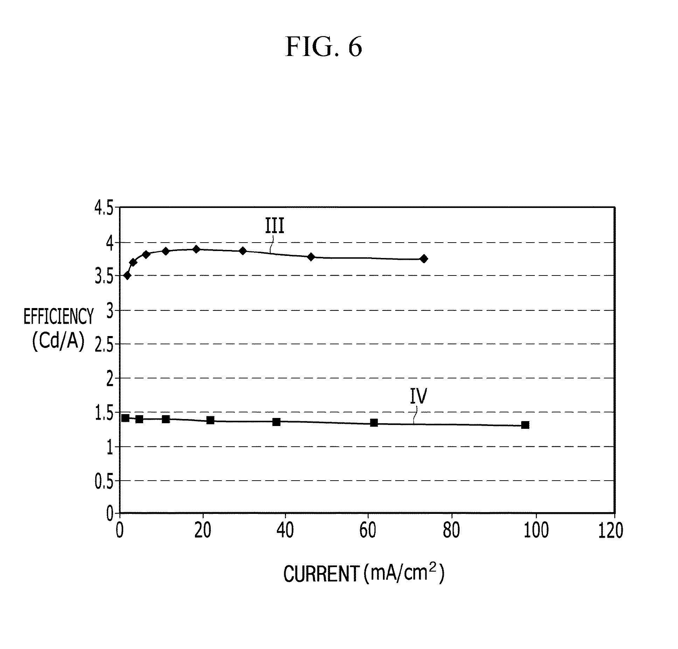

FIG. 5 and FIG. 6 are graphs illustrating light intensity and luminous efficiency of the OLED display according to an exemplary embodiment of the present invention.

The measuring results I and III represent light intensity and luminous efficiency, respectively, of an experimental sample according to an exemplary embodiment. The experimental sample includes an organic light emitting element, where the HIL has a thickness of about 30 nm, the HTL has a thickness of about 20 nm, the emission layer has a thickness of about 20 nm, the ETL has a thickness of 30nm, the second buffer layer has a thickness of 2 nm, the first buffer layer has a thickness of about 90 nm, and the third buffer layer has a thickness of 2 nm. The first buffer layer, the second buffer layer, and the third buffer layer are respectively made of Yb+LiF, MoOₓ, and Yb+LiF. The HIL, the HTL, the emission layer, the ETL are respectively made of DNTPD, NPB, (MADN, BCzVBi), and Alq3.

The measuring results II and IV represents light intensity and luminous efficiency of a comparative sample of a conventional OLED display in which the HIL has a thickness of about 10 nm, the HTL has a thickness of about 130 nm, the emission layer has a thickness of about 20 nm, the ETL has a thickness of about 30 nm, and the electron injection layer (EIL) has a thickness of 1 nm. The HIL, the HTL, the emission layer, the ETL, and the EIL are respectively made of DNTPD, NPB, (MADN, BCzVBi), Alq3, and LiF.

Referring to FIG. 5, the measuring result I for the experimental sample has a maximum intensity at the wavelength of 460 nm and a width P of the maximum wavelength (460 nm)(at an intensity 0.5). The measuring result II for the comparative sample has a maximum intensity at the wavelength of 480 nm and has a width Q(at an intensity 0.5). The width P is smaller than the width Q. Accordingly, the experimental sample emits light whose wavelengths are more concentrated at a specific wavelength of a specific color than the comparative sample. For example, the OLED display according to an exemplary embodiment emits light having a specific wavelength. As a result, the OLED display has an increased image quality.

Referring to FIG. 6, the luminous efficiency III for the experimental sample has higher than the luminous efficiency IV for the comparative sample.

According to an exemplary embodiment, an OLED display has significantly higher luminous efficiency than that of the conventional OLED display, and may prevent damage to an organic light emitting element from occurring due to a sputtering process using multi-layered buffer layers located on an ETL.

## Claims

1. An organic light emitting diode (OLED) display comprising:
a substrate (123);
a thin film transistor (130) formed on the substrate (123);
a first electrode (160) formed on the thin film transistor (130) and electrically connected to the thin film transistor (130);
a hole injection layer (HIL) (171) directly formed on the first electrode (160);
a hole transport layer (HTL) (172) directly formed on the HIL (171);
an emission layer (173) directly formed on the HTL (172);
an electron transport layer (ETL) (174) directly formed on the emission layer (173);
a first buffer layer (175)formed on the ETL (174); and
a second electrode (180) formed on the first buffer layer (176).

2. The OLED display of claim 1, further comprising a second buffer layer (176) formed between the ETL (174) and the first buffer layer (175).

3. The OLED display of claim 2, further comprising a third buffer layer (177) formed between the first buffer layer (175) and the second electrode (180).

4. The OLED display of any of the preceding claims, wherein the first buffer layer (175) comprises CuPc, F₁₆CuPc, MoOₓ, or WO₃.

5. The OLED display of claim 2, wherein the second buffer layer (176) comprises LiF, Yb, WO₃, MoOₓ, Liq, or Mg.

6. The OLED display of claim 3, wherein the third buffer layer (177) comprises LiF, Yb, WO₃, MoOₓ, Liq, or Mg.

7. The OLED display of any of the preceding claims, wherein a thickness of the emission layer (173) ranges from 15 nm to 25 nm.

8. The OLED display of any of the preceding claims, wherein a thickness of the HIL (171) ranges from 25 nm to 35 nm, and a thickness of the HTL (172) ranges from 15 nm to 25 nm.

9. The OLED display of any of the preceding claims, wherein a thickness of the first buffer layer (175) ranges from 85 nm to 95 nm.

10. The OLED display of claim 2, wherein a thickness of the second buffer layer (176) ranges from 1 nm to 3 nm.

11. The OLED display of claim 3, wherein a thickness of the third buffer layer (177) ranges from 1 nm to 3 nm.

12. The OLED display of any of the preceding claims, wherein the first buffer layer (175) is thicker than the HIL (171).
